# EUROPEAN PATENT APPLICATION

(11) **EP 4 202 932 A1**
(43) Date of publication of application: **28.06.2023**
(21) Application number: 22177226.2
(22) Date of filing: 03.06.2022
(51) Int. Cl.: G11C 11/56, G11C 16/06, G06F 12/02

(54) **CONTROL METHOD FOR DYNAMICALLY ADJUSTING RATIO OF SINGLE-LEVEL CELL (SLC) BLOCKS AND THREE-LEVEL CELLS (TLC) BLOCKS**

(30) Priority: 27.12.2021 TW 110148828
(71) Applicant: Giga-Byte Technology Co., Ltd., New Taipei City 231 (TW)
(72) Inventor: HUANG, Ching-Hsun, 231 New Taipei City (TW); LIAO, Tse-Hsien, 231 New Taipei City (TW)
(74) Representative: Michalski Hüttermann & Partner Patentanwälte mbB

(57) **Abstract**

A control method applied in a storage device for dynamically adjusting a ratio of single-level cell (SLC) blocks and three-level cells (TLC) blocks is provided. A selection input is received. The number of SLC blocks and TLC blocks of a flash memory are adjusted according to the selection input. In response to the storage device being reset, the number of SLC blocks and TLC blocks of the flash memory are readjusted.

## Description

### CROSS REFERENCE TO RELATED APPLICATIONS

This Application claims priority of Taiwan Patent Application No. 110148828, filed on December 27, 2021, the entirety of which is incorporated by reference herein.

### BACKGROUND OF THE INVENTION

### Field of the Invention

The invention relates to a control method, and more particularly to a control method for dynamically adjusting the ratio of single-level cell (SLC) blocks and three-level cells (TLC) blocks.

### Description of the Related Art

Generally, two sorts of memory are used in a computer: volatile memory and non-volatile memory. Examples of non-volatile memory include read-only memory (ROM), programmable read-only memory (PROM), erasable programmable read-only memory (EPROM), and flash memory. Examples of volatile memory include dynamic random access memory (DRAM) and static random access memory (SRAM).

### BRIEF SUMMARY OF THE INVENTION

In accordance with an embodiment of the disclosure, a control method is applied in a storage device for dynamically adjusting the ratio of single-level cell (SLC) blocks and three-level cells (TLC) blocks. The control method comprises receiving a selection input; adjusting the number of SLC blocks and TLC blocks of a flash memory according to the selection input; and re-adjusting the number of SLC blocks of the flash memory and the number of TLC blocks of the flash memory in response to the storage device being reset.

In accordance with another embodiment of the disclosure, a storage device dynamically adjusts the ratio of single-level cell (SLC) blocks and three-level cell (TLCs) blocks and comprises a first memory, a flash memory, and a control circuit. The first memory stores a specific file. The flash memory comprises a plurality of blocks. One of the plurality of blocks is a SLC block or a TLC block. The number of SLC blocks of the flash memory is a first value. The number of TLC blocks of the flash memory is a second value. The control circuit adjusts the first value and the second value according to the specific file. In response to the control circuit being reset, the control circuit selects one of a plurality of files stored in a second memory according to a selection input and utilizes the selected file to replace the specific file.

Control method may be practiced by the systems which have hardware or firmware capable of performing particular functions and may take the form of program code embodied in a tangible media. When the program code is loaded into and executed by an electronic device, a processor, a computer or a machine, the electronic device, the processor, the computer or the machine becomes a storage device for practicing the disclosed method.

### BRIEF DESCRIPTION OF THE DRAWINGS

The invention can be more fully understood by referring to the following detailed description and examples with references made to the accompanying drawings, wherein:
FIG. 1 is a schematic diagram of an exemplary embodiment of a storage device according to various aspects of the present disclosure.
FIG. 2A is a schematic diagram of an exemplary embodiment of single-level cell (SLC) blocks and three-level cell (TLC) blocks of a flash memory according to various aspects of the present disclosure.
FIG. 2B is a characteristic curve of an exemplary embodiment of a flash memory according to various aspects of the present disclosure.
FIG. 3 is a flowchart of an exemplary embodiment of a control method according to various aspects of the present disclosure.

### DETAILED DESCRIPTION OF THE INVENTION

The present invention will be described with respect to particular embodiments and with reference to certain drawings, but the invention is not limited thereto and is only limited by the claims. The drawings described are only schematic and are non-limiting. In the drawings, the size of some of the elements may be exaggerated for illustrative purposes and not drawn to scale. The dimensions and the relative dimensions do not correspond to actual dimensions in the practice of the invention.

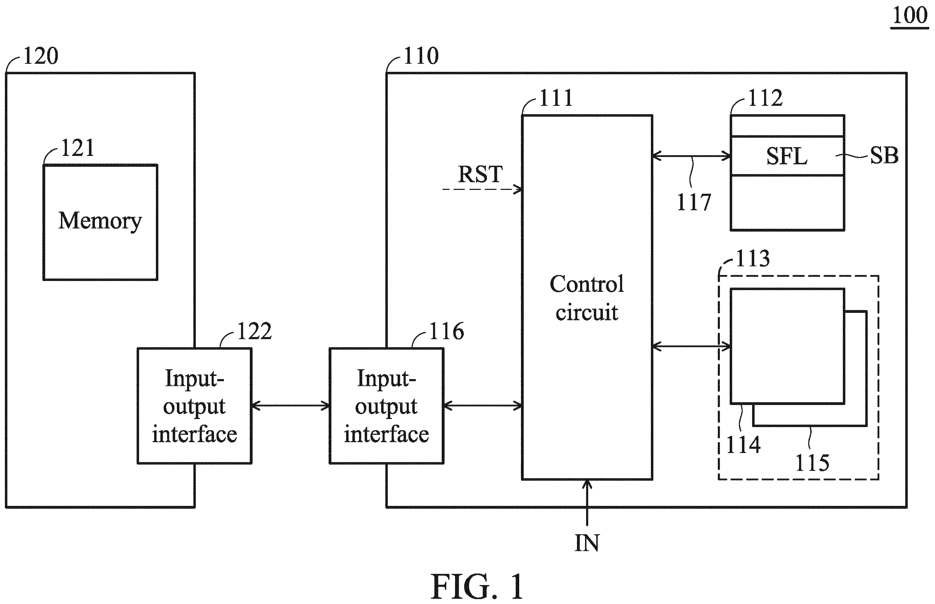

FIG. 1 is a schematic diagram of an exemplary embodiment of a storage device according to various aspects of the present disclosure. The storage device 110 comprises a control circuit 111, a memory 112, and a flash memory 113. The kind of storage device 110 is not limited in the present disclosure. In one embodiment, the storage device 110 is a solid state drive (SSD).

The control circuit 111 dynamically adjusts the ratio of single-level cell (SLC) blocks and three-level cell (TLC) blocks of the flash memory 113. One bit per cell is a SLC block. Three bits per cell is a TLC block. The access speed of the SLC block is faster than the access speed of the TLC blocks. However, the amount of data stored in the TLC blocks is greater than the amount of data stored in the SLC blocks in the same number of blocks.

In one embodiment, the control circuit 111 controls the number of SLC blocks and TLC blocks in the flash memory 113 according to a selection input IN. The selection input IN may be provided by an application. For example, if the user opens a specific application and clicks a "fast" option, the control circuit 111 may increase the number of SLC blocks of the flash memory 113 and decrease the number of TLC blocks of the flash memory 113. In this case, 70% of all blocks of the flash memory 113 are the SLC blocks, and 30% of all blocks of the flash memory 113 are the TLC blocks. However, if the user clicks a "larger size" option, the control circuit 111 may decrease the number of SLC blocks of the flash memory 113 and increase the number of TLC blocks of the flash memory 113. In this case, 30% of all blocks of the flash memory 113 are the SLC blocks, and 70% of all blocks of the flash memory 113 are the TLC blocks. In other embodiments, the selection input IN may be provided from a basic input/output system (BIOS). In this case, the BIOS provides a plurality of options for the user. The control circuit 111 adjusts the number of SLC blocks of the flash memory 113 and the number of TLC blocks of the flash memory 113 according to a corresponding option selected by the user.

The memory 112 is coupled to the control circuit 111 and stores a specific file SFL. The specific file SFL indicates the number of SLC blocks of the flash memory 113 and the number of TLC blocks of the flash memory 113. The type of memory 112 is not limited in the present disclosure. In one embodiment, the memory 112 is a volatile memory, such as double data rate synchronous dynamic random access memory (DDR SRAM). In some embodiments, the control circuit 111 communicates with the memory 112 via a serial peripheral interface (SPI) 117. In other embodiments, the memory 112 is combined in the control circuit 111.

In this embodiment, the memory 112 comprises a specific block SB to store the specific file SFL. In one embodiment, the storage device 110 further comprises an input-output interface 116. The input-output interface 116 is coupled to the storage device 120. The kind of input-output interface 116 is not limited in the present disclosure. In one embodiment, the input-output interface 116 is a universal serial bus (USB) interface, an advanced technology attachment (ATA) interface, a serial advanced technology attachment (SATA) interface, a peripheral component interconnect express (PIC-E) interface.

The control circuit 111 communicates with the storage device 120 via the input-output interface 116. The storage device 120 is a separate device from the storage device 110. The storage device 120 may be another SSD. The structure of the storage device 120 is not limited in the present disclosure. In one embodiment, the storage device 120 at least comprises a memory 121 and an input-output interface 122.

The memory 121 stores a plurality of files. Each file records the number the number of SLC blocks and the number of TLC blocks of the flash memory 113. For example, assuming that the memory 121 stores a first file, a second file, a third file, and a fourth file. In such cases, the first file may indicate that the number of SLC blocks of the flash memory 113 is 0% of all blocks of the flash memory 113, and the number of TLC blocks of the flash memory 113 is 100% of all blocks of the flash memory 113. The second file may indicate that the number of SLC blocks of the flash memory 113 is 30% of all blocks of the flash memory 113, and the number of TLC blocks of the flash memory 113 is 70% of all blocks of the flash memory 113. The third file may indicate that the number of SLC blocks of the flash memory 113 is 70% of all blocks of the flash memory 113, and the number of TLC blocks of the flash memory 113 is 30% of all blocks of the flash memory 113. The fourth file may indicate that the number of SLC blocks of the flash memory 113 is 100% of all blocks of the flash memory 113, and the number of TLC blocks of the flash memory 113 is 0% of all blocks of the flash memory 113.

The input-output interface 122 is coupled to the input-output interface 116 to output the file stored in the memory 121. In one embodiment, the control circuit 111 selects one of the files stored in the memory 121 and stores the selected file in the specific block SB of the memory 112.

The flash memory 113 is coupled to the control circuit 111 and comprises blocks 114 and 115. Each of the blocks 114 and 115 may be a SLC block or a TLC block. In other embodiments, one of the blocks 114 and 115 is a SLC block and the other is a TLC block. For brevity, the blocks 114 and 115 are shown in FIG. 1, but the disclosure is not limited thereto. In other embodiments, the flash memory 113 comprises more blocks. In some embodiments, the flash memory 113 is a NAND flash memory.

The control circuit 111 adjusts the number of SLC blocks and the number of TLC blocks of the flash memory 113 according to the specific file SFL and accesses the flash memory 113. In some embodiments, the control circuit 111 accesses the flash memory 113 via at least one channel (not shown). In this embodiment, when the control circuit 111 is reset, the control circuit 111 selects one of the files stored in a target memory according to the selection input IN. In this case, the control circuit 111 uses the selected file to update the specific file SFL. In one embodiment, the target memory is a memory (e.g., 121) disposed outside of the storage device 110 or the memory (e.g., 112) disposed in the storage device 110. Each file stored in the target memory records a first value and a second value. the first value indicates the number of SLC blocks of the flash memory 113. The second value indicates the number of TLC blocks of the flash memory 113.

In other embodiments, the target memory further stores a table (not shown). The table records a plurality of selection inputs and a plurality of files. Each selection input corresponds to one file. Therefore, the control circuit 111 uses the table stored in a target memory to obtain the address of a corresponding file and reads the target memory to obtain the corresponding file according to the address of the corresponding file. In such cases, the control circuit 111 stores the corresponding file in the specific block SB of the memory 112 and loads the corresponding file from the specific block SB.

In some embodiments, the control circuit 111 further receives a reset signal RST. When the reset signal RST is enabled, the control circuit 111 updates the specific file SFL according to the selection input IN. For example, when the storage device 110 is powered on, the control circuit 111 reads a first file from a target memory according to the selection input IN (referred to as a first selection). The control circuit 111 uses the first file as the specific file SFL and stores the first file in the specific block SB. When the reset signal RST is enabled, the control circuit 111 re-reads the target memory to obtain a second file according to the selection input IN (referred to as a second file). The control circuit 111 uses the second file as the specific file SFL and stores the second file in the specific block SB.

In some embodiments, when the flash memory 113 is idle (i.e., the flash memory 113 does not output data to the control circuit 111 and does not receive data from the control circuit 111), the control circuit 111 determines whether the number of dummy SLC blocks among the SLC blocks of the flash memory 113 is less than a threshold value. The dummy SLC blocks mean that the SLC blocks do not store valid data. In this case, when the number of dummy SLC blocks is not less than the threshold value, the control circuit 111 continually writes data to the dummy SLC blocks of flash memory 113. However, when the number of dummy SLC blocks is less than the threshold value, the control circuit 111 writes data to the TLC blocks of flash memory 113. In other embodiments, when the number of dummy SLC blocks is less than the threshold value, the control circuit 111 may move data from the SLC blocks of flash memory 113 to the TLC blocks of the flash memory 113.

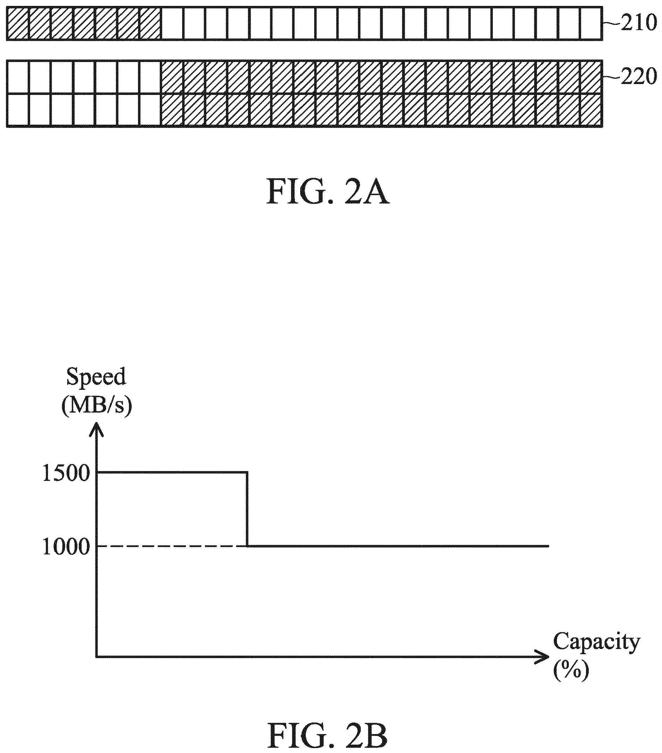

FIG. 2A is a schematic diagram of an exemplary embodiment of a SLC block and a TLC block of the flash memory 113 according to various aspects of the present disclosure. The SLC block 210 and the TLC block 220 have a plurality of cells. In this embodiment, one-third of all cells of the flash memory 113 serve as the cells of the SLC block 210, and two-thirds of all cells of the flash memory 113 serve as the cells of the TLC block 220. When the number of the dummy cells of the SLC block 210 is less than a threshold value, the control circuit 111 writes data to the TCL block 220.

FIG. 2B is a characteristic curve of an exemplary embodiment of the flash memory 113 according to various aspects of the present disclosure. When the control circuit 111 writes data to the SLC block 210, the flash memory 113 transfers about 1500MB of data per second. When the dummy cells of the SLC block 210 is not enough, the control circuit 111 writes data to the TLC block 220. At this time, the flash memory 113 may transfer about 1000MB of data per second.

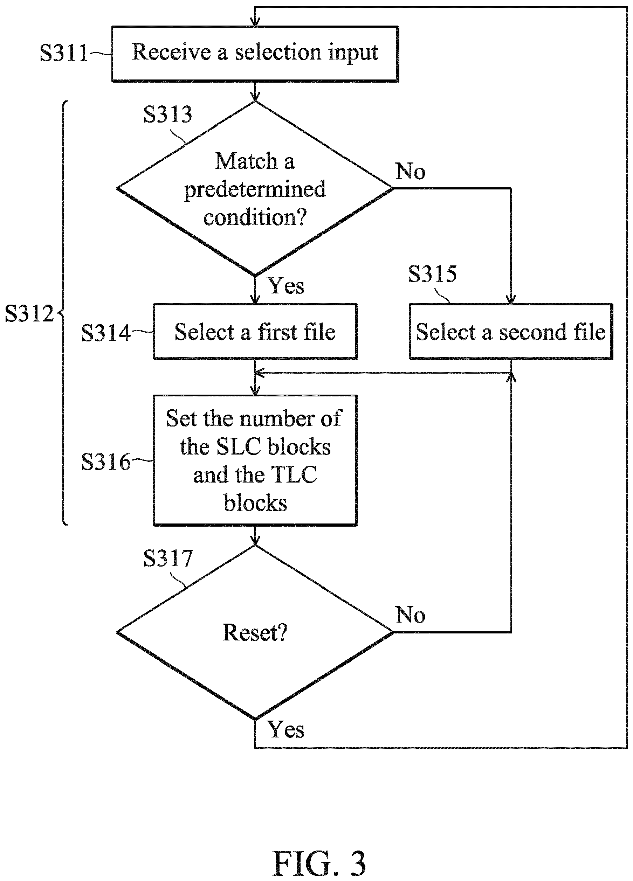

FIG. 3 is a flowchart of an exemplary embodiment of a control method according to various aspects of the present disclosure. The control method is applied in a first storage device to adjust the number of SLC blocks and the number of TLC blocks in the storage device. First, a selection input is received (step S311). In one embodiment, the user may use an application (APP) or a BIOS to provide a selection input.

The number of SLC blocks and the number of TLC blocks in a flash memory are adjusted according to the selection input (step S312). In this embodiment, step S312 comprises steps S313~316. First, a determination is made as to whether the selection input matches a predetermined condition (step S313). When the selection input matches the predetermined condition, the first of a plurality of files is selected to serve as a specific file (step S314). When the selection input does not match the predetermined condition, a second file is selected to serve as the specific file (step S315). The number of SLC blocks and the number of TLC blocks are set according to the specific file (step S316).

In this embodiment, the first and second files indicate different number of SLC blocks and different number of TLC blocks. For example, the first file may indicate that the number of SLC blocks in the flash memory is 30% of all blocks in the flash memory, and the number of TLC blocks in the flash memory is 70% of all blocks in the flash memory. In this case, the second file may indicate that the number of SLC blocks in the flash memory is 70% of all blocks in the flash memory, and the number of TLC blocks in the flash memory is 30% of all blocks in the flash memory.

In some embodiments, steps S314 and S315 read a target memory (referred to as a second memory) to select one of the files to serve as a specific file. In one embodiment, steps S314 and S315 store the specific file in a specific block of the target memory. In another embodiment, steps S314 and S315 store the specific file in another memory (referred to as a first memory). In this case, the first memory may be disposed in the first storage device, and the target memory may be disposed in a second storage device. The first storage device and second storage device can be individual devices.

In other embodiments, step S312 checks a table. The table records the corresponding relationships between a plurality of selection inputs and a plurality of files. Step S312 uses the table to find the address of a file corresponding to the selection input received by step S311.After find the address of the file, step S312 reads the target memory according to the address of the file. In such case, the table may be stored in the target memory. In some embodiments, the table may be stored in another memory which is different from the target memory storing the plurality of files.

In other embodiments, the control method further determines whether a reset event occurs (step S317). If there is no reset event, step S316 is performed to continuously write data to the flash memory. However, when the first storage device is reset, step S311 is performed to re-adjust the number of SLC blocks and TLC blocks of the flash memory (step S312). In this case, step S311 re-receives the selection input, and step S312 selects a corresponding file according to the selection input to update the specific file.

In one embodiment, step S316 further determines whether the number of dummy SLC blocks of the flash memory is less than a threshold value. When the number of dummy SLC blocks of the flash memory is not less than the threshold value, step S316 writes data to the dummy SLC blocks of the flash memory. However, when the number of dummy SLC blocks of the flash memory is less than the threshold value, step S316 writes data to the TLC blocks of the flash memory. In other embodiments, when the number of dummy SLC blocks of the flash memory is less than the threshold value, step S316 moves a portion of data in the SLC blocks of the flash memory to the TLC blocks of the flash memory.

Since the number of SLC blocks and TLC blocks of a flash memory can be adjust according to different requirements, the flash memory can satisfy different requirements. For example, when the storage device is idle, a determination is made as to whether the dummy SLC blocks have sufficient capacity. If the free capacity of the SLC blocks is lower than a threshold value, a portion of data stored in the SLC blocks is moved to the TLC blocks. Therefore, the storage device maintains fast write speed.

It will be understood that when an element or layer is referred to as being "on", "connected to" or "coupled to" another element or layer, it can be directly on, connected or coupled to the other element or layer or intervening elements or layers may be present. In contrast, when an element or layer is referred to as be "directly on", "directly connected to" or "directly coupled to" another element or layer, there are no intervening elements or layers present.

Control methods, or certain aspects or portions thereof, may take the form of a program code (i.e., executable instructions) embodied in tangible media, such as floppy diskettes, CD-ROMS, hard drives, or any other machine-readable storage medium, wherein, when the program code is loaded into and executed by a machine such as a computer, the machine thereby becomes a storage device for practicing the methods. The methods may also be embodied in the form of a program code transmitted over some transmission medium, such as electrical wiring or cabling, through fiber optics, or via any other form of transmission, wherein, when the program code is received and loaded into and executed by a machine such as a computer, the machine becomes a storage device for practicing the disclosed methods. When implemented on a general-purpose processor, the program code combines with the processor to provide a unique apparatus that operates analogously to application-specific logic circuits.

Unless otherwise defined, all terms (including technical and scientific terms) used herein have the same meaning as commonly understood by one of ordinary skill in the art to which this invention belongs. It will be further understood that terms, such as those defined in commonly used dictionaries, should be interpreted as having a meaning that is consistent with their meaning in the context of the relevant art and will not be interpreted in an idealized or overly formal sense unless expressly so defined herein. It will be understood that although the terms "first," "second," etc. may be used herein to describe various elements, these elements should not be limited by these terms. These terms are only used to distinguish one element from another.

While the invention has been described by way of example and in terms of the preferred embodiments, it should be understood that the invention is not limited to the disclosed embodiments. On the contrary, it is intended to cover various modifications and similar arrangements (as would be apparent to those skilled in the art). Therefore, the scope of the appended claims should be accorded the broadest interpretation so as to encompass all such modifications and similar arrangements.

## Claims

1. A control method applied in a first storage device for dynamically adjusting a ratio of single-level cell (SLC) blocks and three-level cells (TLC) blocks, comprising:
receiving a selection input;
adjusting the number of SLC blocks and TLC blocks of a flash memory according to the selection input; and
re-adjusting the number of SLC blocks and TLC blocks of the flash memory in response to the first storage device being reset.

2. The control method as claimed in claim 1, wherein the step of adjusting the number of SLC blocks and TLC blocks of the flash memory according to the selection input comprises:
selecting one of a plurality of files as a specific file according to the selection input.

3. The control method as claimed in claim 2, further comprising:
storing the specific file in a specific block of a first memory.

4. The control method as claimed in claim 3, wherein the plurality of files are stored in a second storage device disposed independently of the first storage device, or wherein the plurality of files are stored in the first memory.

5. The control method as claimed in claim 2, further comprising:
storing a table, wherein the table records corresponding relationships between a plurality of selection inputs and the plurality of files.

6. The control method as claimed in any of claims 1 to 5, further comprising:
determining whether the number of dummy SLC blocks of the flash memory is less than a threshold value,
wherein in response to the number of dummy SLC blocks of the flash memory not being less than the threshold value, data is written to the dummy SLC blocks of the flash memory.

7. The control method as claimed in claim 6, wherein in response to the number of dummy SLC blocks of the flash memory being less than the threshold value, the data is written to the TLC blocks of the flash memory, or wherein in response to the number of dummy SLC blocks of the flash memory being less than the threshold value, data stored in at least one of the SLC blocks of the flash memory is moved to the TLC blocks of the flash memory.

8. A storage device for dynamically adjusting a ratio of single-level cell (SLC) blocks and three-level cell (TLCs) blocks, comprising:
a first memory storing a specific file;
a flash memory comprising a plurality of blocks, wherein one of the plurality of blocks is one of the SLC blocks or one of the TLC blocks, the number of SLC blocks is a first value, and the number of TLC blocks is a second value; and
a control circuit adjusting the first value and the second value according to the specific file,
wherein in response to the control circuit being reset, the control circuit selects one of a plurality of files stored in a second memory according to a selection input and utilizes the selected file to replace the specific file.

9. The storage device as claimed in claim 8, wherein the second memory is the first memory, the first memory stores the plurality of files and comprises a specific block, the specific block is configured to store the specific file, the control circuit selects one of the plurality of files according to the selection input, and stores the selected file in the specific block.

10. The storage device as claimed in claim 8, wherein the second memory is a separate electronic component from the storage device.

11. The storage device as claimed in any of claims 8 to 10, further comprising:
an input-output interface configured to be coupled to the second memory.

12. The storage device as claimed in any of claims 8 to 11, wherein the first memory is combined into the control circuit.

13. The storage device as claimed in any of claims 8 to 12, wherein the second memory stores a table which records corresponding relationships between a plurality of selection inputs and the plurality of files.

14. The storage device as claimed in any of claims 8 to 13, wherein:
the flash memory comprises a plurality of SLC blocks and a plurality of TLC blocks, the control circuit determines whether the number of dummy SLC blocks of the plurality of SLC blocks is less than a threshold value, and
in response to the number of dummy SLC blocks among the plurality of SLC blocks not being less than the threshold value, the control circuit writes data to the plurality of SLC blocks.

15. The storage device as claimed in claim 14, wherein in response to the number of dummy SLC blocks of the plurality of SLC blocks being less than the threshold value, the control circuit writes data to the plurality of TLC blocks, or wherein in response to the number of dummy SLC blocks among the plurality of SLC blocks being less than the threshold value, the control circuit moves a portion of data from the plurality of SLC blocks to the plurality of TLC blocks.
